# EUROPEAN PATENT APPLICATION

(11) **EP 3 258 490 A1**
(43) Date of publication of application: **20.12.2017**
(21) Application number: 16425053.2
(22) Date of filing: 13.06.2016
(51) Int. Cl.: H01L 23/532, H01L 23/525

(54) **A METHOD OF MANUFACTURING SEMICONDUCTOR DEVICES AND CORRESPONDING DEVICE**

(71) Applicant: STMicroelectronics S.r.l., 20864 Agrate Brianza (MB) (IT)
(72) Inventor: Molgg, Michele, I-20864 Agrate Brianza (Monza Brianza) (IT); Scime', Fabio, I-20871 Vimercate (Monza Brianza) (IT)
(74) Representative: Bosotti, Luciano

(57) **Abstract**

In one embodiment, a method of manufacturing semiconductor devices including metallizations (e.g. a Re-Distribution Layer - RDL metallizations 10) includes:
- providing a capping stack (141, 161, 142, 162) onto the metallizations (10), wherein the stack includes at least one nickel layer,
- including in the stack (141, 161, 142, 162) a pair of nickel layers (141, 142) having therebetween a layer of ductile material (161) such as palladium or gold.

## Description

### Technical field

The description relates to manufacturing semiconductor devices.

One or more embodiments may apply e.g. to thermo-mechanical stress reduction in integrated circuits, e.g. for automotive and consumer products.

### Technological background

Various types of integrated circuits (ICs) may adopt technologies such as BCD (Bipolar-CMOS-DMOS) technology.

BCD technology may be advantageously used e.g. for producing integrated circuits with both power electronics and logical control electronics. BCD technology provides a family of silicon processes, each of which combines the strengths of three different process technologies onto a single chip: bipolar for precise analog functions, CMOS (Complementary Metal Oxide Semiconductor) for digital design and DMOS (Double Diffused Metal Oxide Semiconductor) for power and high-voltage elements.

Implementing BCD technology may involve top layer copper metal interconnections, called Re-Distribution Layer (RDL).

This may involve using a copper RDL module as the final metal. Such a module may include a Cu line/pad/power metallization (e.g. 10 micrometer - 10. 10⁻⁶ meter - high) covered by a layer or stack of e.g. Ni and Pd layers.

Also, silicon nitride (SiN) or silicon carbide (SiC) may be used in manufacturing ICs to provide a passivation layer for microchips, e.g. to provide a barrier against water molecules and other sources of corrosion and instability in microelectronics.

Taking into account mechanical stress issues on passivation materials (e.g. Si nitrides) induced by the thermo-mechanical expansion/contraction of metallic materials (Ni, Pd, Cu, Ti, W) may facilitate achieving satisfactory results. In that respect, a contribution to the local stress on passivation was obeserved to be related to Ni expansion, with stress increasing during thermal treatment due to the Cu/Ni/Pd thermal expansion coefficient mismatch, while these effects were found to increase as Ni thickness increases.

### Object and summary

An object of one or more embodiments is to contribute in taking into account the critical issues mentioned in the foregoing.

According to one or more embodiments, that object may be achieved by means of a method having the features set forth in the claims that follow.

One or more embodiments may also relate to a corresponding device.

The claims are an integral part of the technical disclosure of one or more embodiments has provided herein.

One or more embodiments may facilitate taking into account mechanical stress issues in passivation materials (e.g. Si nitrides) which may be induced by thermo-mechanical expansion/contraction of metallic materials such as Ni, Pd, Cu, Ti, W.

One or more embodiments may involve an alternate deposition (e.g. electro-less or e-less deposition) of Ni/Pd to reduce stress effects.

Even without wishing to be bound to any specific theory in that respect, the ductility of an e.g. Pd interlayer may be held to absorb the mechanical stress during the thermal cycle.

In one or more embodiments, a thin ductile (e.g. Pd) layer may be formed between two Ni layers, in order to reduce and decouple stress contributions.

One or more embodiments may benefit from Ni deposition on Pd being practicable without Ni surface chemical pre-treatment.

One or more embodiments may involve Ni Pd electroless deposition (named e-less) multilayer deposition on e.g. RDL copper: four layers of Ni and Pd deposited in alternate sequence (Ni/Pd/Ni/Pd) in order to reduce the mechanical stress over a thermal cycle.

One or more embodiments may adopt other types of (e.g. e-less) deposition different from (e.g. Cu) Ni-Pd-Ni-Pd.

Depositions such as:
(Cu) Ni-Pd-Ni-Pd-Au
(Cu) Ni-Au-Ni-Pd
(Cu) Ni-Au-Ni-Pd-Au
are exemplary of such alternative deposition options.

### Brief description of the figures

One or more embodiments will now be described, purely by way of example, with reference to the annexed figures, in which:
- Figure 1 is a top view of a stack arrangement which may incorporate one or more embodiments,
- Figure 2 is a reproduction of a SEM-microscope cross-section across a conventional (single) stack arrangement, and
- Figure 3 is a reproduction of a SEM microscope cross-section across a (double) stack arrangement according to embodiments.

It will be appreciated that for the sake of clarity of representation certain features of the figures (e.g. layer thicknesses) may not be drawn to scale.

### Detailed description

In the ensuing description, one or more specific details are illustrated, aimed at providing an in-depth understanding of examples of embodiments in the present description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

Document EP 1 320 129 B1 discloses a semiconductor electronic device comprising a die of semiconductor material and a support, the die of semiconductor material including an integrated electronic circuit and a plurality of contact pads associated with the electronic circuit and connected electrically to the support by wire leads. Each contact pad comprises a lower layer of aluminium, copper, or alloys thereof, and an upper layer comprising at least one film of a metal and/or metallic alloy selected from a group comprising nickel, palladium, and alloys thereof, and being deposited by an electroless chemical process.

While not referring to RDL technology and, more to the point, not disclosing multiple layers of the type contemplated in one or more embodiments the disclosure of EP 1 320 129 B1 provides some background information on such processes.

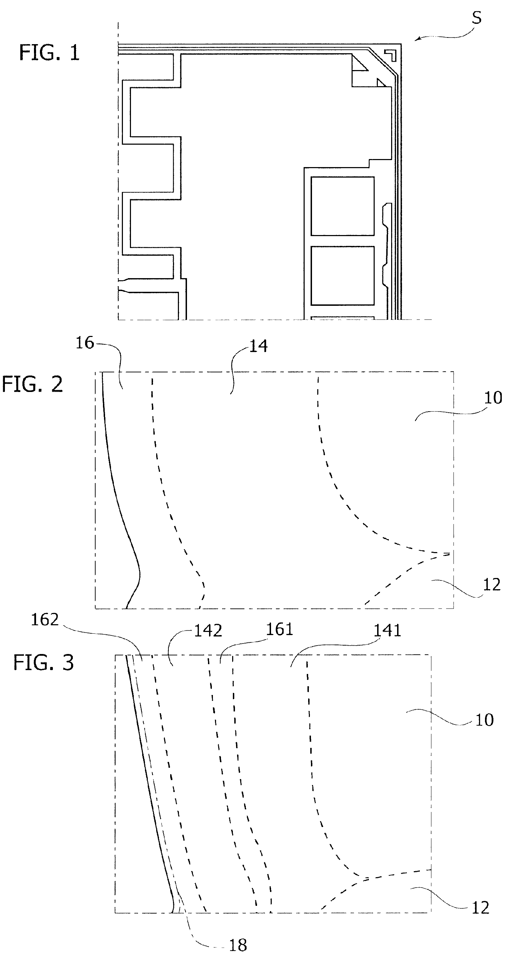

Figure 1 is a top view of a portion of a semiconductor device S produced e.g. by BCD-RDL technology including a stack arrangement which may incorporate one or more embodiments.

The semiconductor device S (e.g. an integrated circuit - IC) may be produced by meanos of a RDL process including (in a manner known per se) a sequence of steps leading to the formation of RDL metallizations 10 e.g. Cu with an underlying barrier layer 12 e.g. TiW or other barrier materials such as TiN/Ti/Tin Ta/Tan.

A combined (stacked) outer surface coating or "capping" may then be provided on the outer surface of the metallization 10, the coating or capping having a thickness of e.g. approximately 2 micron (2 x 10⁻⁶ m).

In a conventional arrangement as exemplified in Figure 2, such a stacked capping (that is, a multilayer) may include a Ni-Pd layer with e.g. Ni at 14, Pd at 16. In other conventional arrangements, the stacked capping may include Ni-Pd-Au or Ni-Au multiple layers.

While successfully adopted in production, such a Ni/Pd layer may exhibit a certain amount of stress, e.g. if exposed to temperatures in the range of e.g. 300° - 400° C.

Specifically, it was observed that such a "single" Ni-Pd stack 14, 16 can induce too high a stress on a passivation layer during a thermal cycle.

One or more embodiments as exemplified in Figure 3 may reduce the local stress due to e.g. the Ni layer by resorting to "multiple" stacked arrangement, including, starting from the (e.g. Cu) metallization 10:
- a first Ni layer 141,
- a first (thin) Pd layer 161,
- a second Ni layer 142,
- a second Pd layer 162.

In one or more embodiments, a (thin e.g. 0.1-0.5 micron 0.1-0.5 x 10⁻⁶ m) layer 161 of a ductile material e.g. Pd may be provided between two Ni layers 141, 142.

In one or more embodiments, the presence of the layer 161 (Pd, or possibly, other ductile materials such as e.g. Au) may lead to the Ni stress being "decoupled" into two separate contributes, lower in magnitude due to the ductility of the layer 161.

Even without wishing to be bound to any specific theory in that respect, the ductility of an e.g. Pd interlayer may be held to absorb the mechanical stress during a thermal cycle.

Also, one or more embodiments may benefit from Ni deposition on e.g. Pd being practicable without any Ni surface chemical pre-treatment.

Additionally, no differences may be observed on wafers (dice) by optical inspection see e.g. the exemplary enlarged view of Figure 1.

In one or more embodiments by resorting to an alternate deposition of e.g. Ni/Pd/Ni/Pd (see e.g. 141, 161, 142, 162) on e.g. copper could reduce the stress effect due to the ductility of Pd interlayer that can absorb the mechanical stress during the thermal cycle.

One or more embodiments may facilitate meeting with request specifications for power packages used e.g. in the automotive field.

As indicated, one or more embodiments may include stacked depositions other than Ni (layer 141) - Pd (layer 161) - Ni (layer 142) - Pd (layer 162).

Such alternative depositions may include e.g.
- using another ductile material (e.g. Au) for the layer 161, and/or
- an outer layer (e.g. Au as schematically indicated in chain line as 18 in Figure 3) at the outer surface of the stack.

Depositions such as:
(Cu) Ni-Pd-Ni-Pd-Au
(Cu) Ni-Au-Ni-Pd
(Cu) Ni-Au-Ni-Pd-Au
are thus exemplary of such alternative deposition options.

The following may be exemplary thickness values for layers in a stack according to one or more embodiments:
- layer 141: 0.1-0.5 micron (0.1-0.5 x 10⁻⁶ m)
- layer 161: 0.1-0.5 micron (0.1-0.5 x 10⁻⁶ m
- layer 142 : 0.5-1.5 micron (0.5-1.5) x 10⁻⁶ m
- layer 162: 0.2-0.5 micron (0.2-0.5 x 10⁻⁶ m

One or more embodiments may thus provide a method of manufacturing semiconductor devices including at least one metallization (e.g. 10), the method including:
- providing (e.g. by e-less deposition) a capping stack (e.g. 141, 161, 142, 162) onto said metallization, wherein said stack includes at least one nickel layer,
- including in said stack a pair of nickel layers (e.g. 141, 142) having sandwiched therebetween a layer of ductile material (e.g. 161).

In one or more embodiments, said ductile material may be selected out of palladium (Pd) and gold (Au).

One or more embodiments may include providing said metallization as a copper metallization, optionally as a Re-Distribution Layer - RDL metallization.

One or more embodiments may include providing in said stack, opposed said metallization, at least one outer layer (e.g. 162, 18) of ductile material.

One or more embodiments may include providing in said stack, opposed said metallization, a first outer layer (e.g. 162) including palladium and an outermost layer (e.g. 18) including gold.

One or more embodiments may include providing a barrier layer (e.g. 12) underlying said at least one metallization.

In one or more embodiments, said barrier layer underlying said at least one metallization may include TiW.

One or more embodiments may include providing the capping stack adjoining said barrier layer (see e.g. Figure 3, bottom right) to provide full coverage of said at least one metallization.

One or more embodiments may provide a semiconductor device including:
- at least one metallization (e.g. 10), and
- a capping stack (e.g. 141, 161, 142, 162; 18) provided onto said metallization, wherein said stack includes a pair of nickel layers having a layer of ductile material therebetween.

In one or more embodiments:
- said ductile material (161) may be selected out of palladium and gold, and/or
- the stack may include, opposed said metallization, at least one outer layer of ductile material.

Without prejudice to the underlying principles, the details and embodiments may vary, even significantly, with respect to what has been disclosed merely by way of example, without departing from the extent of protection.

The extent of protection is defined by the annexed claims.

## Claims

1. A method of manufacturing semiconductor devices including at least one metallization (10), the method including:
- providing a capping stack (141, 161, 142, 162) onto said metallization (10), wherein said stack includes at least one nickel layer,
- including in said stack (141, 161, 142, 162) a pair of nickel layers (141, 142) having a layer of ductile material (161) therebetween.

2. The method of claim 1, wherein said ductile material (161) is selected out of palladium and gold.

3. The method of claim 1 or claim 2, including providing said metallization (10) as a copper metallization, preferably as a Re-Distribution Layer - RDL metallization.

4. The method of any of the previous claims, including providing in said stack, opposed said metallization (10), at least one outer layer (162, 18) of ductile material.

5. The method of claim 4, including providing in said stack, opposed said metallization (10), a first outer layer (162) including palladium and an outermost layer (18) including gold.

6. The method of any of the previous claims, including providing a barrier layer (12) underlying said at least one metallization (10).

7. The method of claim 6, including:
- providing said barrier layer (12) underlying said at least one metallization (10) including TiW, and/or
- providing the capping stack (141, 161, 142, 162) adjoining said barrier layer (12) underlying said at least one metallization (10) to provide full coverage of said at least one metallization (10).

8. The method of any of the previous claims, including providing in said stack (141, 161, 142, 162) onto said metallization by e-less deposition.

9. A semiconductor device including:
- at least one metallization (10), and
- a capping stack (141, 161, 142, 162) provided onto said metallization (10), wherein said stack includes a pair of nickel layers (141, 142) having a layer of ductile material (161) therebetween.

10. The semiconductor device of claim 9, wherein:
- said ductile material (161) is selected out of palladium and gold, and/or
- the stack includes, opposed said metallization (10), at least one outer layer (162, 18) of ductile material.
